(19) Europäisches Patentamt / European Patent Office / Office européen des brevets

(11) **EP 4 521 446 A1**

(12) **EUROPEAN PATENT APPLICATION**
published in accordance with Art. 153(4) EPC

(43) Date of publication:
**12.03.2025 Bulletin 2025/11**

(21) Application number: **22969066.4**

(22) Date of filing: **29.12.2022**

(51) International Patent Classification (IPC):
**H01L 21/02** (2006.01)

(52) Cooperative Patent Classification (CPC):
**H01L 21/02; H01L 21/762; H10D 86/00**

(86) International application number:
**PCT/CN2022/143558**

(87) International publication number:
**WO 2024/130779 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.12.2022 CN 202211652519**

(71) Applicant: **Zhonghuan Advanced Semiconductor Technology Co., Ltd.**
**Wuxi, Jiangsu 214203 (CN)**

(72) Inventors:
• **MA, Qianzhi**
  **Wuxi, Jiangsu 214203 (CN)**
• **SUN, Chenguang**
  **Wuxi, Jiangsu 214203 (CN)**
• **WANG, Yanjun**
  **Wuxi, Jiangsu 214203 (CN)**
• **YAO, Zuying**
  **Wuxi, Jiangsu 214203 (CN)**
• **MA, Kun**
  **Wuxi, Jiangsu 214203 (CN)**
• **ZHANG, Yuhang**
  **Wuxi, Jiangsu 214203 (CN)**
• **ZHANG, Qi**
  **Wuxi, Jiangsu 214203 (CN)**
• **WEI, Qiwang**
  **Wuxi, Jiangsu 214203 (CN)**
• **LUO, Chaoyang**
  **Wuxi, Jiangsu 214203 (CN)**
• **GU, Haiyun**
  **Wuxi, Jiangsu 214203 (CN)**
• **LI, Zhicai**
  **Wuxi, Jiangsu 214203 (CN)**

(74) Representative: **Herrero & Asociados, S.L.**
**Edificio Aqua - Agustín de Foxá, 4-10**
**28036 Madrid (ES)**

(54) **SILICON-ON-INSULATOR WAFER, PREPARATION METHOD AND SEMICONDUCTOR APPARATUS**

(57) Disclosed are a silicon-on-insulator wafer, a preparation method and a semiconductor apparatus. The silicon-on-insulator wafer comprises: a first substrate and a top silicon layer, wherein the first substrate comprises a first surface; the first substrate has a maximum dimension $D_{max}$ in a first direction; the first surface has a second dimension $D_2$ in the first direction; the maximum dimension and the second dimension meet the condition of $100 \ \mu m \leq D_{max}-D_2 \leq 500 \ \mu m$; and the top silicon layer is disposed on the first surface. In the silicon-on-insulator wafer provided in the present application, by optimizing edge dimensions of the first substrate and the first surface, a suitable position is provided for the preparation of the top silicon layer, thereby facilitating the obtainment of a silicon-on-insulator wafer having a relatively small step width. The present application further provides a method for preparing the silicon-on-insulator wafer, and a semiconductor apparatus comprising the silicon-on-insulator wafer.

EP 4 521 446 A1

FIG. 1

**Description**

**CROSS-REFERENCE TO RELATED APPLICATIONS**

This application claims the benefit of Chinese Patent Application No. 202211652519.9 filed on Dec. 21, 2022 and entitled "SILICON-ON-INSULATOR WAFER, PREPARATION METHOD AND SEMICONDUCTOR APPARATUS", the disclosures of which are incorporated by reference herein in their entirety.

**TECHNICAL FIELD**

The application belongs to the technical field of semiconductor wafer, and in particular, relates to a silicon-on-insulator wafer, a preparation method, and a semiconductor apparatus.

**BACKGROUND**

At present, the preparation of silicon-on-insulator wafer mainly comprises separation by implanted oxygen technology, smart cut technology and bonding etch-back technology. Wherein, the bonding etch-back technology is a process of thinning the device layer substrate after bonding the support substrate and the device layer substrate, and attracts attention due to possess the characteristics such as simple process and low cost. However, restricted to the process conditions during thinning, the unbonded part of the edge of the device layer substrate needs to be removed through additional grinding or etching processes, which makes it difficult to accurately control the dimension and uniformity of the device layer substrate, the using performance of silicon-on-insulator wafer is directly affected.

**TECHNICAL PROBLEMS**

Purpose of application: this application provides a silicon-on-insulator wafer, in order to realize that unbonded region of the edge of the device layer substrate can shed automatically during the thinning process; another purpose of this application is to provide a preparation method of silicon-on-insulator wafer; another purpose of this application is to provide a semiconductor apparatus comprising the above-mentioned silicon-on-insulator wafer.

**BRIEF SUMMARY OF THE INVENTION**

First aspect, a silicon-on-insulator wafer of this application, comprises:

a first substrate, the first substrate comprises a first surface, wherein, the first surface has a maximum dimension $D_{max}$ along a first direction, the first surface has a second dimension $D_2$ along the first direction, satisfying $100\mu m \leq D_{max} - D_2 \leq 500\mu m$;
a top silicon layer, the top silicon layer is disposed on the first surface.

In some embodiments, the maximum dimension $D_{max}$ and the second dimension $D_2$ satisfy: $100\ \mu m \leq D_{max} - D_2 \leq 160\ \mu m$.
In some embodiments, the top silicon layer has a first dimension $D_1$ along the first direction, satisfying: $D_{max} - D_1 \leq 2mm$.
In some embodiments, the top silicon layer is formed by performing chemical mechanical polishing on the bonding region; the bonding region has an eighth dimension $D_0$ along the first direction, the top silicon layer has a first dimension $D_1$ along the first direction, satisfying: $D_1 - D_0 \leq 0.1\ mm$.
In some embodiments, the top silicon layer has a first dimension $D_1$ along the first direction; the first dimension $D_1$, the the second dimension $D_2$ and the maximum dimension $D_{max}$ satisfy:

$$0.1 \leq (D_{max} - D_2) / (D_{max} - D_1) \leq 1.$$

In some embodiments, the first substrate further comprises a second surface disposed along a second direction and facing away from the first surface, the second surface has a third dimension $D_3$ along the first direction, satisfying:

$$1 \leq D_2 / D_3 \leq 1.5.$$

In some embodiments, a first arc surface is disposed from an edge of the first surface to an edge of the first substrate, a second arc surface is disposed from an edge of the second surface to the edge of the first substrate, the first arc surface has a fifth dimension $L_5$ along the first direction, the second arc surface has a sixth dimension $L_6$ along the first direction, satisfying:

$$0.01 \leq L_5 / L_6 \leq 1.$$

In some embodiments, the silicon-on-insulator wafer further satisfies:

$$50\mu m \leq L_5 \leq 80\mu m;$$

and/or,

$$220\mu m \leq L_6 \leq 450\mu m.$$

In some embodiments, further comprises:

a first oxide layer, the first oxide layer is disposed between the first substrate and the top silicon layer, the first oxide layer is in contact with the first surface;
a second oxide layer, the second oxide layer is disposed on a side of the first substrate facing away from the top silicon layer, the second oxide layer is in contact with the second surface.

In some embodiments, the top silicon layer has a thickness along a second direction, the second direction is perpendicular with the first direction; the thickness of the top silicon layer) in the second direction is 3 to $20\mu m$; and/or,

a distance between the first surface and the second surface is 400 to $1000\mu m$; and/or,
a thickness of the first oxide layer in the second direction is 0.1 to $2\mu m$; and/or,
a thickness of the second oxide layer in the second direction is 0.1 to $2\mu m$.

Second aspect, this application further provides a preparation method of a silicon-on-insulator wafer, comprising following steps:

providing a first substrate, the first substrate comprises a first surface, wherein, the first surface has a maximum dimension $D_{max}$ along a first direction, the first surface has a second dimension $D_2$ along the first direction, satisfying $100\mu m \leq D_{max} - D_2 \leq 500\mu m$;
providing a second substrate, the second substrate comprises a third surface;
contacting the third surface with the first surface, so that the second substrate and the first substrate are bonded and annealed, and the second substrate comprises a bonding region and a separation region; the separation region is disposed around the bonding region to connect an edge of the bonding region;
thinning a side of the second substrate facing away from the third surface, so that the separation region falls off, the position of the separation region forms step, the step surrounds the bonding region;
forming, by the bonding region, a top silicon layer on the first substrate.

In some embodiments, the maximum dimension $D_{max}$ and the second dimension $D_2$ satisfy: $100\mu m \leq D_{max} - D_2 \leq 160\ \mu m$.

The top silicon layer has a first dimension $D_1$ along the first direction, satisfying:

$$D_{max} - D_1 \leq 2\ mm.$$

In some embodiments, after thinning a side of the second substrate facing away from the third surface, the side of the second substrate facing away from the third surface comprises a stress damage layer; the step of forming, by the bonding region, a top silicon layer on the first substrate comprises:
performing chemical mechanical polishing on a side of the second substrate facing away from the third surfaceto remove the stress damage layer firstly; forming the top silicon layer after performing chemical mechanical polishing on the bonding region.

In some embodiments, the bonding region has an eighth dimension $D_0$ along the first direction, the top silicon layer has a first dimension $D_1$ along the first direction, satisfying:

$$D_1 - D_0 \leq 0.1 \text{ mm}.$$

In some embodiments, the top silicon layer has a first dimension $D_1$ along the first direction; the first dimension $D_1$, satisfying:

$$0.1 \leq (Dmax - D2) / (Dmax - D1) \leq 1.$$

In some embodiments, the first substrate further comprises a second surface disposed along a second direction and facing away from the first surface; the second substrate further comprises a fourth surface disposed along a second direction and facing away from the third surface;
wherein, the second surface has a third dimension $D_3$ along the first direction, the fourth surface has a third dimension $D_4$ along the first direction, satisfying:

$$1 \leq D_2 / D_3 \leq 1.5;$$

and/or,

$$1 \leq D_2 / D_4 \leq 1.5.$$

In some embodiments, a first arc surface is disposed from an edge of the first surface to an edge of the first substrate, a second arc surface is disposed from an edge of the second surface to the edge of the first substrate, the first arc surface has a fifth dimension $L_5$ along the first direction, the second arc surface) has a fifth dimension $L_6$ along the first direction, satisfying: $0.01 \leq L_5 / L_6 \leq 1$.

In some embodiments, a third arc surface is disposed from an edge of the third surface to an edge of the second substrate, a fourth arc surface is disposed from an edge of the fourth surface to the edge of the second substrate, the third arc surface is connected with the fourth arc surface; the third arc surface has a seventh dimension $L_7$ along the first direction, the fourth arc surface has a sixth dimension $L_8$ along the first direction, satisfying:

$$0.01 \leq L_7 / L_8 \leq 1;$$

and/or,

$$0.01 \leq L_7 / L_5 \leq 1.$$

In some embodiments, after providing the first substrate, further comprises:
oxidizing the first substrate to form a first oxide layer on the first surface and/or to form a second oxide layer on the second surface.

In some embodiments, the annealing specifically refers to: under the environment of the nitrogen or oxygen, raising the temperature to 900 to 1200 °C at a rate of 2 to 5 °C / min, then keep for 4 to 6 hours.

In some embodiments, in thinning a side of the second substrate facing away from the third surface, the thinning is mechanical grinding.

In some embodiments, the removal amount of the chemical and mechanical polishing is 4 to 5 $\mu$m.

Third aspect, this application further provides a semiconductor apparatus, the semiconductor comprises the silicon-on-insulator wafer; or, the semiconductor apparatus comprises a silicon-on-insulator wafer obtained by the preparation method.

**BENEFICIAL EFFECT**

Compared with the prior art, a silicon-on-insulator wafer of the present application comprises: a first substrate, the first substrate comprises a first surface, wherein, the first surface has a maximum dimension $D_{max}$ along a first direction, the first surface has a second dimension $D_2$ along the first direction, satisfying $100\mu m \leq D_{max} - D_2 \leq 500\mu m$; a top silicon layer, the top silicon layer is disposed on the first surface. The silicon-on-insulator wafer provided in this application provides a suitable position for the preparation of the top silicon layer by optimizing the edge dimension of the first substrate, which is beneficial to obtain a silicon-on-insulator wafer with a narrower step width.

A preparation method of a silicon-on-insulator wafer of the present application, comprises the following steps: providing a first substrate, the first substrate comprises a first surface, wherein, the first surface has a maximum dimension $D_{max}$ along a first direction, the first surface has a second dimension $D_2$ along the first direction, satisfying $100\mu m \leq D_{max} - D_2 \leq 500\mu m$; providing a second substrate, the second substrate comprises a third surface; contacting the third surface with the first surface, so that the second substrate and the first substrate are bonded and annealed, and the second substrate comprises a bonding region and a separation region; the separation region is disposed around the bonding region to connect an edge of the bonding region; thinning a side of the second substrate facing away from the third surface, so that the separation region falls off, the falling off position of the separation region forms a step, the step surrounds the bonding region; forming, by the bonding region, a top silicon layer on the first substrate. In the preparation method of the present application, by optimizing the annealing process of the first substrate and the second substrate, the bonding force of the 1 to 3 mm region of the edge can be enhanced, and by optimizing the grinding process in the mechanical thinning process, the unbonded region of the edge can shed automatically during the thinning process, and the width of automatically falling off does not exceed 1 mm, so that the width non-uniformity of the top silicon layer is smaller than or equal to 5 %; in this way, under the condition of without the process of the chamfer grinding and the chamfer etching, the width of the step edge can be minimized by optimizing the topography of the substrate, bonding and thinning process, not only the process cost can be reduced, but also a narrower step width of a silicon-on-insulator wafer can be obtained.

It can be understood that, compared with the prior art, the semiconductor apparatus provided by the embodiment of the present application possesses all the technical features and beneficial effects of the silicon-on-insulator wafer described above, which will not be repeated here.

**BRIEF DESCRIPTION OF THE DRAWINGS**

The technical solutions and other beneficial effects of the present application will be apparent from the following detailed description of specific embodiments of the present application with reference to the accompanying drawings.

FIG. 1 is a schematic structural diagram of a silicon-on-insulator wafer provided in an embodiment of the present application;

FIG. 2 is a schematic diagram of a partial structure of a silicon-on-insulator wafer provided in an embodiment of the present application;

FIG. 3 is a schematic structural diagram of a first substrate provided in an embodiment of the present application;

FIG. 4 is a schematic structural diagram of a second substrate provided in an embodiment of the present application;

FIG. 5 is a schematic structural diagram of bonding of the first substrate and the second substrate provided by the embodiment of the present application;

FIG. 6 is a schematic structural diagram of thinning the second substrate provided by the embodiment of the present application;

FIG. 7 is a schematic diagram of of the separation region falls off automatically provided by the embodiment of the present application;

FIG. 8 is a comparison of uniformity of the step width of Example 1 and Comparative Example 4 of the present application;

Reference numerals, 1-first substrate, 2-top silicon layer, 3-first oxide layer, 4-second oxide layer, 5-second substrate, 11-first surface, 12-second surface, 13-first arc surface, 14-second arc surface, 51-third surface, 52-fourth surface, 53-third arc surface, 54-fourth arc surface, 501-bonding region, 502-separation region .

**IMPLEMENTATIONS OF THIS APPLICATION**

This application provides a silicon-on-insulator wafer and a preparation method, a semiconductor apparatus, in order to make the purpose, technical solutions and effects of the present application clearer and more explicit, the present application will be further described in detail below with reference to the accompanying drawings and examples. It should be understood that the specific embodiments described here are only used to explain the present application and are not used to limit the present application.

With unique structure, silicon-on-insulator wafer can realize vertical isolation in the true physical sense through the buried oxide layer (BOX) in the vertical direction, and can realize lateral isolation through the deep trench isolation oxide layer (DTI) in the horizontal direction; components can be made on different isolation islands, which can reduce or eliminate the common electric leakage and latch-up effects in bulk silicon power devices, and improve the integration density of circuits. At the same time, since silicon-on-insulator wafer technology has lower leakage current than bulk silicon components, so that can work at higher voltage and higher temperature. While giving full play to the advantages of bulk silicon integrated circuits, the latch-up effect and parasitic capacitance are completely eliminated, and the leakage channel to the substrate is completely blocked, thereby possessing the excellent characteristics of high speed and low power consumption, and gradually becoming the first choice for manufacturing semiconductor integrated circuit devices with integration, high speed, low power consumption and high reliability.

At present, the preparation technologies of silicon-on-insulator substrate materials mainly comprises separation by implanted oxygen technology, smart cut technology and bonding etch-back technology. The thickness of the top silicon layer and the thickness of the buried oxide layer of the wafer prepared by separation by implanted oxygen technology are very uniform, however, due to the limitation of the implanting process of the oxygen ion, the thickness of the device silicon layer cannot exceed 300 nm, the thickness of the buried oxide layer cannot exceed 240 nm, and in the buried oxide layer, some discontinuous silicon island defects are often found, which makes the breakdown voltage of the buried oxide layer much worse than that of conventional thermal oxidation; thus limiting the product application and technical development of separation by implanted oxygen technology; the smart cut technology has the advantages of technology maturity, good uniformity of the device layer and low process cost, and has become the mainstream preparation technology of 8-inch power silicon-on-insulator substrate materials; bonding etch-back technology has the characteristics of simple process and low cost, and the wafer-on-insulator prepared by which has crystal defect density and surface quality compared with bulk silicon wafer, and can be adjusted within a wide range. However, restricted to the thinning process, it is difficult to accurately control the thickness uniformity of the device silicon layer, and the non-uniformity is generally $\pm$ 0.5$\mu$m, therefore, it is mainly used in the field of high-voltage power devices or MEMS devices, and most of them are concentrated in 4 to 6 inches.

The silicon-on-insulator wafer prepared by the three technologies, except that the implant oxygen technology is based on the implantation and annealing process of a polished wafer, retains the original substrate wafer edge morphology, that is, there are no steps on the edge, and after bonding and thinning the silicon-on-insulator wafer prepared by the two technologies of smart cut technology and bonding etch-back technology, there is a circle of steps formed by removing the edge part of the device silicon layer on the edge of the top device silicon layer in order to release the edge stress, the width of the step is affected by the process and appears the situation of different widths, taking the smart cut technology as an example, the width of the edge step of the final silicon-on-insulator wafer varies from 1 mm to 2.8 mm, the effective area of the device silicon layer is reduced due to too wide step width, the yield rate of the chip is reduced, and easily results in that product quality and electrical performance parameters are affected by defects produced by the edge in the subsequent process.

In the bonding etch-back process, although there are edge chamfering and alkali etching processes to remove the edge part of the device silicon layer, the process cost of the silicon-on-insulator wafer is also greatly increased due to the addition of the chamfering process and the alkali etching process; therefore, and the alkaline etching process is prone to corrosion defects; therefore, a narrow and uniform step width is obtained, the process costs is reduced, there is great significance for improving the quality of silicon-on-insulator wafer.

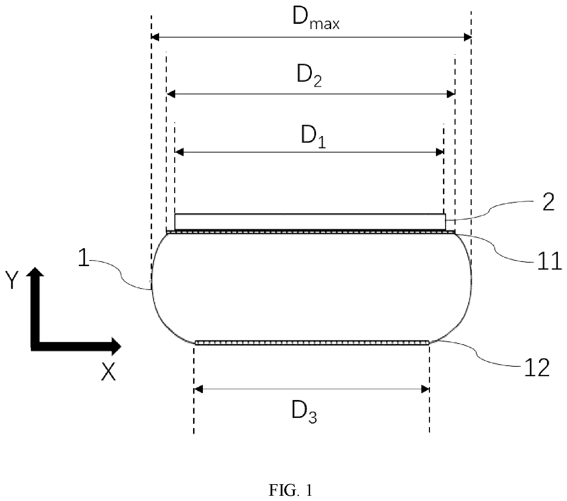

Refers to FIG. 1, the present application provides a silicon-on-insulator wafer, comprises: a first substrate 1, the first substrate 1 is provided with a first surface 11, top silicon layer 2, the top silicon layer 2 is disposed on the first surface 11; wherein, the first substrate 1 has a maximum dimension $D_{max}$ along a first direction X, the first surface has a second dimension $D_2$ along the first direction X, satisfying $100\mu m \leq D_{max} - D_2 \leq 500\mu m$.

In some embodiments, by optimizing the edge dimension of the first substrate 1 and the first surface 11, a suitable position is provided for the preparation of the top silicon layer 2, which is beneficial to obtain a silicon-on-insulator wafer with a narrower step width. It can be understood that the first direction X is the direction indicated by the horizontal arrow in FIG. 1, and the second direction Y is the direction indicated by the vertical arrow in FIG. 1. the first direction and the second direction are only schematically used for indicating the positional relationship and dimension between the first substrate 1 and the top silicon layer 2, the first direction and the second direction are not limited to the directions shown in the figure, and the first direction and the second direction intersect in space, preferably are perpendicular to each other. The first direction and the second direction in this embodiment both refer to the settings in FIG. 1.

In some embodiments, preferably, the maximum dimension $D_{max}$ and the second dimension $D_2$ satisfy: $100\mu m \leq D_{max} - D_2 \leq 160\mu m$.

In some embodiments, the top silicon layer 2 has a first dimension $D_1$ along the first direction X, satisfying: $D_{max} - D_1 \leq 2$ mm. In case where $D_{max} - D_1 \leq 2$ mm is satisfied, not only can guarantee the quality of the top silicon layer 2, but also can obtain a narrow and uniform step width.

In some embodiments, the top silicon layer 2 is formed by performing chemical mechanical polishing on the bonding region 501; the bonding region 501 has an eighth dimension $D_0$ along the first direction X, the top silicon layer 2 has a first dimension $D_1$ along the first direction, satisfying: $D_1 - D_0 \leq 0.1$ mm. Wherein, $D_0 < D_1$.

In some embodiments, by controlling the chemical mechanical polishing process, the first dimension $D_1$ and the eighth dimension $D_0$ satisfy: $D_1 - D_0 \leq 50\mu m$.

In some embodiments, by controlling the chemical mechanical polishing process, the first dimension $D_1$ and the eighth dimension $D_0$ can be equal, that is $D_0 = D_1$.

In some embodiments, the top silicon layer 2 has a first dimension $D_1$ along the first direction X; the first dimension $D_1$, the second dimension $D_2$ and the maximum dimension $D_{max}$, satisfying:

$$0.1 \leq (D_{max} - D_2) / (D_{max} - D_1) \leq 1.$$

In some embodiments, in case where $(D_{max} - D_2) / (D_{max} - D_1)$ is smaller than 0.1, on the one hand, it will cause the step width of the top silicon layer 2 to be larger, and at the same time, it may also cause the edge of the supporting substrate to chip; in case where $(D_{max} - D_2) / (D_{max} - D_1)$ is greater than 1, the edge of the top device layer cannot shed automatically during the thinning process, and may also cause silicon edge of the top device layer to chip; in case where $0.1 \leq (D_{max} - D_2) / (D_{max} - D_1) \leq 1$ is satisfied, it is guaranteed to obtain a silicon-on-insulator wafer with a narrow step width and no edge chipping effect is produced. Further preferably, the range of $(D_{max} - D_2) / (D_{max} - D_1)$ satisfies: $0.1 \leq (D_{max} - D_2) / (D_{max} - D_1) \leq 0.5$, furthermore, the range of $(D_{max} - D_2) / (D_{max} - D_1)$ satisfies: $0.1 \leq (D_{max} - D_2) / (D_{max} - D_1) \leq 0.3$.

In some embodiments, in order to ensure the integrity of the first substrate 1, the first substrate 1 further comprises a second surface 12 disposed along the second direction, the second surface 12 is disposed facing away from the first surface 11, the second surface 12 has a third dimension $D_3$ along the first direction, satisfying: $1 \leq D_2/D_3 \leq 1.5$. The second surface 12 can be a surface with a same area as the first surface 11 or a different area with the first surface 11.

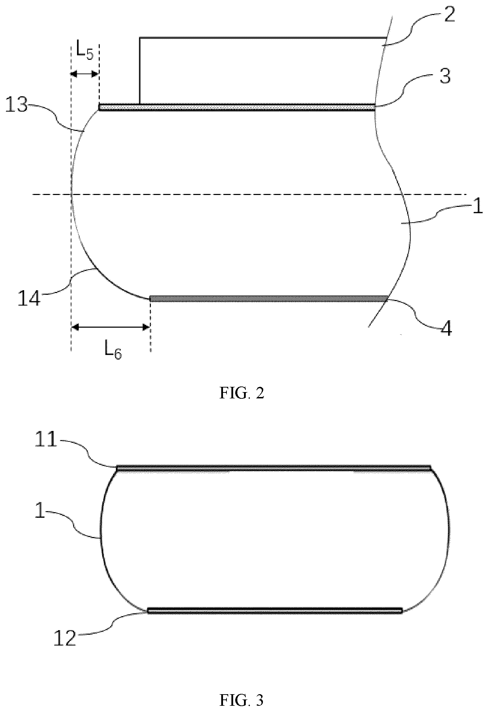

In some embodiments, in order to facilitate processing, both the first surface 11 and the second surface 12 of the first substrate 1 need to be chamfered, after chamfering, an arc surface will be formed on the edge of the first substrate 1, referriing to FIG. 2, a first arc surface 13 is disposed from an edge of the first surface 11 to an edge of the first substrate 1, a second arc surface 14 is disposed from an edge of the second surface 12 to the edge of the first substrate 1, the first arc surface 13 has a fifth dimension $L_5$ along the first direction, the second arc surface 14 has a fifth dimension $L_6$ along the first direction, satisfying: $0.01 \leq L_5/L_6 \leq 1$. In case where the value of $L_5/L_6$ is 1, indicating that the chamfers of the first surface 11 and the second surface 12 of the first substrate 1 are symmetrical up and down, in case where the value of $L_5/L_6$ is smaller than 1, indicating that the chamfers on the first surface 11 and the second surface 12 of the first substrate 1 are asymmetrical.

In some embodiments, the silicon-on-insulator wafer further satisfies: $50\mu m \leq L_5 \leq 80\mu m$; $220\mu m \leq L_6 \leq 450\mu m$. Further preferred ranges satisfy: $60\mu m \leq L_5 \leq 70\mu m$; $300\mu m \leq L_6 \leq 400\mu m$.

In some embodiments, referring to FIG. 2, the silicon-on-insulator wafer further comprises: a first oxide layer 3 and a second oxide layer 4, the first oxide layer 3 is disposed between the first substrate 1 and the top silicon layer 2, the first oxide layer 3 is in contact with the first surface 11; the second oxide layer 4 is disposed on a side of the first substrate 1 facing away from the top silicon layer 2, the second oxide layer 4 is in contact with the second surface 12.

In some embodiments, the top silicon layer 2 has a thickness along the second direction Y, the second direction Y is perpendicular to the first direction X, a thickness of the top silicon layer 2 in the second direction Y is 3 to $20\mu m$; a distance between the first surface 11 and the second surface 12 is 400 to $1000\mu m$; a thickness of the first oxide layer 3 in the second direction Y is 0.1 to $2\mu m$; a thickness of the second oxide layer 4 in the second direction Y is 0.1 to $2\mu m$. Further preferably, the thickness of the top silicon layer 2 in the second direction Y is 5 to $10\mu m$; the distance between the first surface 11 and the second surface 12 is 600 to $800\mu m$; the thickness of the first oxide layer 3 in the second direction Y is 0.5 to $1\mu m$; the thickness of the second oxide layer 4 in the second direction Y is 0.5 to $1\mu m$.

In some embodiments, the present application further provides a preparation method of a silicon-on-insulator wafer, comprising the following steps:

Referring to FIG. 1 and FIG. 3, providing a first substrate 1, the first substrate 1 comprises a first surface 11, wherein, the first substrate 1 has a maximum dimension $D_{max}$ along a first direction X, the first surface 11 has a second dimension $D_2$ along the first direction X, satisfying $100\mu m \leq D_{max} - D_2 \leq 500\mu m$.

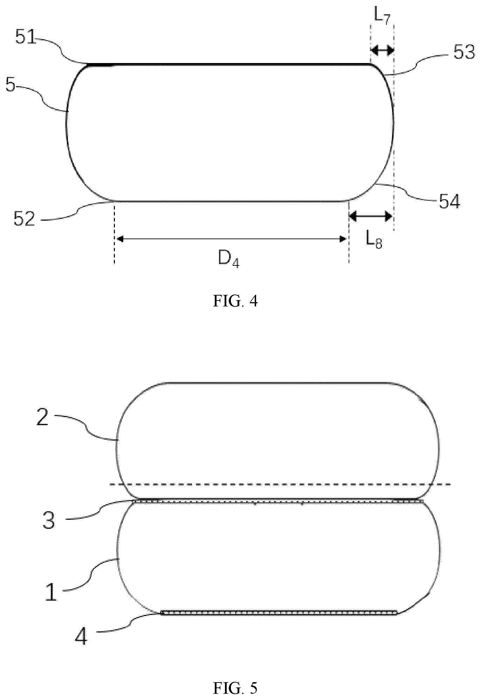

Referring to FIG. 4, providing a second substrate 5, the second substrate 5 comprises a third surface 51.

Referring to FIG. 5, FIG. 6 and FIG.7, contacting the third surface 51 with the first surface 11, so that the second substrate 5 and the first substrate 1 are bonded and annealed, and the second substrate 5 comprises a bonding region 501 and a separation region 502; the separation region 502 is disposed around the bonding region 501 to connect an edge of the bonding region 501; thinning a side of the second substrate 5 facing away from the third surface 51, so that the separation region 502 falls off; the bonding region 501 forms a top silicon layer 2 on the first substrate 1.

In some embodiments, by optimizing the annealing process of the first substrate 1 and the second substrate 5, the bonding force of the 1 to 3 mm region of the edge can be enhanced, and by optimizing the grinding process in the mechanical thinning process, the unbonded region of the edge can shed automatically during the thinning process, and the width of automatically falling off does not exceed 1 mm, so that the width non-uniformity of the top silicon layer 2 is smaller than or equal to 5 %; in this way, under the condition of without the process of the chamfer grinding and the chamfer etching, the width of the step edge can be minimized by optimizing the topography of the substrate.

In some embodiments, the top silicon layer 2 is a step structure relative to the first substrate 1, and the distance between the edge of the top silicon layer 2 and the edge of the first substrate 1 is the width of the step structure, and the width can be expressed as $(D_{max} - D_1) / 2$, the dimension of the width determines the overall dimension of the top silicon layer 2, since the part of the separation region 502 can automatically shed during the thinning process, the smaller the width, the more to guarantee that the thickness at the edge of the top silicon layer 2 remains consistent in any direction, thereby achieving uniformity of the width of the top silicon layer 2.

In some embodiments, the first substrate 1 refers to a conventional polished silicon wafer, or a thermal oxidation wafer with a silicon dioxide film formed on the surface through dry oxygen oxidation or wet oxygen oxidation; one surface of the first substrate 1 is a polished surface, the doping type and resistivity are not limited, the edge topography is symmetrical or asymmetrical chamfering; the second substrate 5 is a conventional polished silicon wafer, or a silicon epitaxial wafer; one surface of the second substrate 5 is a polished surface, the doping type and resistivity are not limited, the edge topography is symmetrical or asymmetrical chamfering.

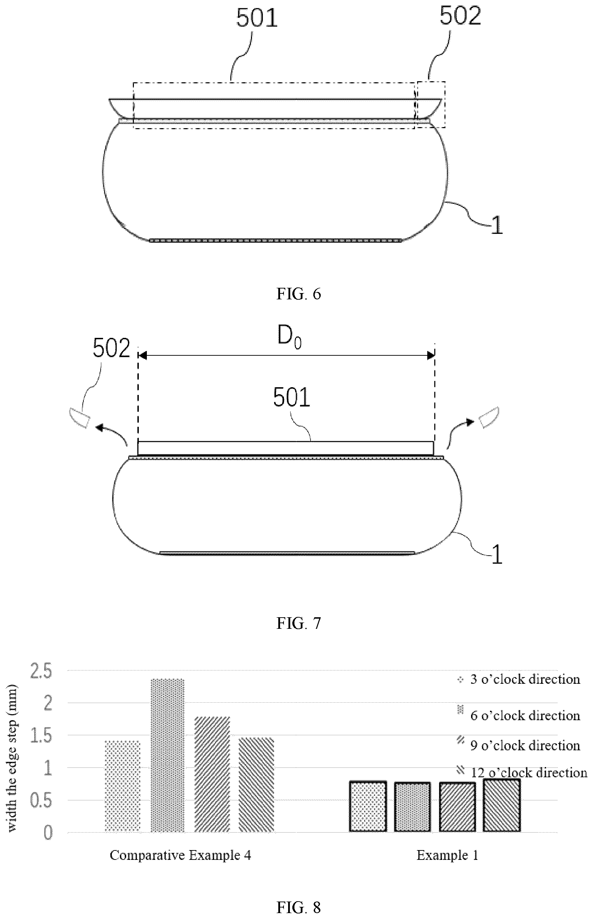

In some embodiments, referring to FIG. 7 and FIG. 1, thinning a side of the second substrate 5 facing away from the third surface 51, so that the separation region 502 falls off, the thinning makes the side of the second substrate 5 facing away from the third surface 51 comprises a stress damage layer; the step of the bonding region 501 forms a top silicon layer 2 on the first substrate 1 comprises: performing chemical mechanical polishing on a side of the second substrate 5 facing away from the third surface 51 to remove the stress damage layer firstly; forming the top silicon layer 2 after performing chemical mechanical polishing on the bonding region 501.

In some embodiments, referring to FIG. 7, the bonding region 501 has an eighth dimension $D_0$ along the first direction, the top silicon layer 2 has a first dimension $D_1$ along the first direction X, satisfying: $D_1 - D_0 \le 0.1$ mm.

In some embodiments, referring to FIG. 4, the second substrate 5 further comprises a fourth surface 52 disposed along the second direction Y, the fourth surface 52 is disposed facing away from the third surface 51; wherein, the fourth surface 52 has a third dimension $D_4$ along the first direction, satisfying: $1 \le D_2 / D_4 \le 1.5$.

In some embodiments, referring to FIG. 4, a third arc surface 53 is disposed from an edge of the third surface 51 to an edge of the second substrate 5, a fourth arc surface 54 is disposed from an edge of the fourth surface 52 to the edge of the second substrate 5, the third arc surface 53 is connected with the fourth arc surface 54; the third arc surface 53 has a seventh dimension $L_7$ along the first direction X, the fourth arc surface 54 has a sixth dimension $L_8$ along the first direction X, satisfying: $0.01 \le L_7 / L_8 \le 1$; $0.01 \le L_7 / L_5 \le 1$. Wherein, in case where the value of $L_7 / L_8$ is 1, indicating that the chamfers on the third surface 51 and the fourth surface 52 of the second substrate 5 are symmetrical up and down, in case where the value of $L_7 / L_8$ is smaller than 1, indicating that the chamfers on the third surface 51 and the fourth surface 52 of the second substrate is asymmetrical; in addition, by further defining the range of $L_7 / L_5$, which can avoid the the dimension of the chamfers on the third surface 51 of the second substrate 5 is too large or too small relative to the dimension of the chamfers on the first surface 11 of the first substrate 1 from causing the quality of the top silicon layer 2 to be affected. This is because when the dimension is too large, the chamfered region is difficult to shed automatically during the thinning process after bonding, but if the dimension is too small, which will cause the width of the step of the top silicon layer 2 is too large, affect the performance of device prepared subsequently.

In some embodiments, referring to FIG. 3 , after providing the first substrate 1, further comprises: oxidizing the first substrate 1 to form a first oxide layer 3 on the first surface 11 and to form a second oxide layer 4 on the second surface 12.

In some embodiments, in bonding and annealing the second substrate 5 with the first substrate 1, the bonding refers to: attaching the first surface 11 of the first substrate 1 to the third surface 51 of the second substrate 5; the annealing specifically refers to: under the environment of the nitrogen or oxygen, raising the temperature to 900 to 1200 °C at a rate of 2 to 5 °C / min, then keep for 4 to 6 hours. In some embodiments, introducing $H_2$ or $O_2$ and perform the annealing through water vapor formed by the way of hydrogen-oxygen ignition.

In some embodiments, the process of bonding and annealing is as follows: transferring the bonded first substrate 1 and the second substrate 5 together to a vertical furnace or a horizontal furnace, controlling the rasing rate of the temperature not to exceed 6 °C/min, raise the temperature to exceed 1000 °C to perform the annealing, nitrogen or oxygen can be introduced during the annealing process, the annealing lasts not less than 2 hours; the preferred annealing temperature is 1150 °C, the rasing rate of the temperature is 3 °C/min, the annealing lasts 5 h, the gas introduced is oxygen.

In some embodiments, referring to FIG. 6 and FIG. 7, thinning a side of the second substrate 5 facing away from the third surface 51, the thinning is mechanical grinding, the grinding wheel is in hard contact during the process of the mechanical grinding so that part of the edge not bonded falls off automatically and evenly, that is, the separation region 502 falls off automatically.

In some embodiments, using the way of mechanical grinding for thinning; mechanical grinding refers to perform mechanical grinding to the fourth surface 52 of the second substrate 5 through a high-speed rotating spindle driving a grinding wheel on a single-piece thinning equipment, using a coarse grinding wheel to grind to remove most of the substrate silicon firstly, and then using a fine grinding wheel to grind with a small removal amount, controlling the removal amount and feed or exit speed of fine grinding to achieve the target thickness that the thickness of the silicon of the final device layer not to exceed $40\mu m$; the unbonded part of the edge of the silicon of the device falls off automatically and evenly during the process of the thinning, eventually forms an edge step with a step width smaller than or equal to 1 mm and a uniform width.

In some embodiments, using the way of combination of performing the rough grinding with a coarse grinding wheel and performing the fine grinding with a fine grinding wheel to perform thinning and removing, the mesh number of the coarse grinding wheel is smaller than or equal to 500 mesh, the mesh number of the fine grinding wheel is larger than or equal to 3000 mesh; controlling the feed or exit speed not to exceed 5 $\mu m$ / second during the process of the fine grinding; grinding to the target thickness; the preferred coarse grinding wheel is 300 to 400 mesh, the preferred fine grinding wheel is 5000 to 8000 mesh; the preferred feed or exit speed during the process of the fine grinding is 3 to 4 $\mu m$ / second.

In some embodiments, the removal amount of the mechanical grinding is larger than or equal to $600\mu m$.

In some embodiments, the top silicon layer 2 is formed by performing chemical mechanical polishing on the bonding region 501, the removal amount of the chemical mechanical polishing is 4 to $5\mu m$. The preferred polishing method is chemical mechanical polishing (CMP). Chemical mechanical polishing refers to the use of single-chip polishing to remove the surface stress damage caused by mechanical grinding during the previous thinning process and at the same time improve the surface roughness to achieve surface roughness level of conventional polishing discs. Because the bonding force of the edge is large enough, the width of the edge step does not change significantly after chemical mechanical polishing, that is, $D_1 - D_0 \leq 0.1$ mm, thus maintaining a relatively narrow step width and excellent width uniformity. Performing the chemical mechanical polishing to the bonding substrate after grinding, not only completely removes the stress damage layer caused by grinding, but also fully meets the requirements of the surface roughness, but controls the removal amout of the polishing at the same time to reduce the deteriorating influence of unevenness of the thickness of the silicon layer of the device; the preferred removal amount of the polishing is 4 to $5\mu m$. The polishing process has basically no impact to the edge width of the device layer, the change of the vallue before and after of the width is smaller than or equal to 0.1 mm, which can maintain the regularity of the edge width.

In some embodiments, the present application further provides a semiconductor apparatus, the semiconductor apparatus comprises the above silicon-on-insulator wafer.

Multiple groups of silicon-on-insulator wafers are prepared according to the preparation method mentioned above, specifically comprising Examples 1 to 16, and Comparative Examples 1 to 3. The obtained width data refers to Table 1. In the table, $\triangle D$ represents $(D_{max} - D_2) / (D_{max} - D_1)$, the range of $\triangle D$ in Comparative Examples 1 to 3 is not within the range set in this embodiment.

Table 1

| | $\triangle D$ | $D_{max}$-$D_2$ $\mu m$ | thickness of top silicon $\mu m$ | annealing temperature °C | width $(D_{max} - D_1)$ / 2 mm |
|---|---|---|---|---|---|
| Example 1 | 0.19 | 500 | 3 | 1150 | 1.287 |
| Example 2 | 0.18 | 500 | 8 | 1150 | 1.362 |
| Example 3 | 0.17 | 500 | 15 | 1150 | 1.495 |
| Example 4 | 0.16 | 500 | 8 | 950 | 1.594 |
| Example 5 | 0.16 | 500 | 8 | 1050 | 1.522 |
| Example 6 | 0.16 | 160 | 3 | 1150 | 0.513 |
| Example 7 | 0.13 | 160 | 8 | 1150 | 0.609 |
| Example 8 | 0.12 | 160 | 15 | 1150 | 0.688 |
| Example 9 | 0.11 | 160 | 8 | 950 | 0.692 |
| Example 10 | 0.12 | 160 | 8 | 1050 | 0.647 |
| Example 11 | 0.20 | 100 | 3 | 1150 | 0.245 |
| Example 12 | 0.16 | 100 | 8 | 1150 | 0.313 |
| Example 13 | 0.14 | 100 | 15 | 1150 | 0.365 |

(continued)

| | $\triangle D$ | $D_{max}$-$D_2$ $\mu m$ | thickness of top silicon $\mu m$ | annealing temperature °C | width ($D_{max}$ - $D_1$) / 2 mm |
|---|---|---|---|---|---|
| Example 14 | 0.13 | 100 | 8 | 950 | 0.395 |
| Example 15 | 0.14 | 100 | 8 | 1050 | 0.348 |
| Example 16 | 0.12 | 500 | 8 | 1150 | 1.945 |
| Comparative Example 1 | 0.08 | 500 | 8 | 1150 | 2.945 |
| Comparative Example 2 | 0.04 | 160 | 8 | 1150 | 1.889 |
| Comparative Example 3 | 0.02 | 100 | 8 | 1150 | 1.848 |

It can be seen from Table 1 that $D_{max}$ - $D_2$ in Examples 1 to 16 meets the requirements of 100 to 500 $\mu m$, and ($D_{max}$ - $D_2$) / ($D_{max}$ - $D_1$) meets the limited range of 0.1 to 1, which can ensure that the width from the top silicon layer 2 to the edge is controlled within a relatively small range, thereby obtaining a silicon-on-insulator wafer with a narrower step width; in Comparative Examples 1 to 3, in case where ($D_{max}$ - $D_2$) / ($D_{max}$ - $D_1$) is smaller than 0.1, the width from the top silicon layer 2 to the edge is relatively large, which is not conducive to the uniformity of the width of the top silicon layer 2 and also affects the performance of subsequent device.

Comparative Example 4

Using Smart-cut technology to prepare silicon-on-insulator wafer, that is, injecting hydrogen ions into one bonded wafer and then bonded to another silicon wafer at a certain temperature. In case where the thermal treatment temperature of the bonding is about 500 °C, the position where the hydrogen ion implants forms a continuous cavity, which will automatically shed to form a silicon-on-insulator wafer. Comparing Comparative Example 4 with the silicon-on-insulator wafer of Example 1 of the present application, referring to FIG. 8, the widths of the edge step of Example 1 of the present application are all equal in four directions, showing extremely excellent width uniformity; while the widths of the edge step are all different in four directions after the Comparative Example 4 uses the Smart-cut technology, therefore, the preparation method of this application optimizes the grinding process so that the unbonded region of the edge falls off automatically during the thinning process, that is, the separation region 502 falls off automatically, the width of automatically falling off does not exceed 1mm, the unevenness of the width of the top silicon layer 2 is relatively small; in this way, under the condition of without the process of the chamfer grinding and the chamfer etching, the width of the step edge can be minimized by optimizing the topography of the substrate, bonding and thinning process.

The silicon-on-insulator wafer and a preparation method, a semiconductor apparatus provided by the present application have been introduced in detail above. Specific examples are used in this article to illustrate the principles and implementation methods of the present application. The description of the above embodiments is only used to help understanding. The method of this application and its core idea; at the same time, for those skilled in the art, there will be changes in the specific implementation and application scope based on the ideas of this application. In summary, the contents of this specification should not be understood as a limitation on this application.

**Claims**

1.  A silicon-on-insulator wafer, wherein, the silicon-on-insulator wafer comprises:

    a first substrate (1), the first substrate (1) comprises a first surface (11), wherein, the first surface (11) has a maximum dimension $D_{max}$ along a first direction, the first surface (11) has a second dimension $D_2$ along the first direction, satisfying $100\mu m \leq D_{max} - D_2 \leq 500\mu m$;
    a top silicon layer (2), the top silicon layer (2) is disposed on the first surface (11).

2.  The silicon-on-insulator wafer according to claim 1, wherein the maximum dimension $D_{max}$ and the second dimension $D_2$ satisfy: $100\mu m \leq D_{max} - D_2 \leq 160\mu m$.

3.  The silicon-on-insulator wafer according to any one of claims 1 to 2, wherein the top silicon layer (2) has a first dimension $D_1$ along the first direction, satisfying: $D_{max} - D_1 \leq 2mm$.

4. The silicon-on-insulator wafer according to any one of claims 1 to 3, wherein the top silicon layer (2) is formed by performing chemical mechanical polishing on the bonding region (501); the bonding region (501) has an eighth dimension $D_0$ along the first direction, the top silicon layer (2) has a first dimension $D_1$ along the first direction, satisfying: $D_1 - D_0 \leq 0.1$ mm.

5. The silicon-on-insulator wafer according to any one of claims 1 to 4, wherein the top silicon layer (2) has a first dimension $D_1$ along the first direction; the first dimension $D_1$, the second dimension $D_2$ and the maximum dimension $D_{max}$ satisfy:

$$0.1 \leq (D_{max}-D_2) / (D_{max}-D_1) \leq 1.$$

6. The silicon-on-insulator wafer according to any one of claims 1 to 5, wherein the first substrate (1) further comprises a second surface (12) disposed along a second direction and facing away from the first surface (11), the second surface (12) has a third dimension $D_3$ along the first direction, satisfying:

$$1 \leq D_2 / D_3 \leq 1.5.$$

7. The silicon-on-insulator wafer according to claim 6, wherein a first arc surface (13) is disposed from an edge of the first surface (11) to an edge of the first substrate (1), a second arc surface (14) is disposed from an edge of the second surface (12) to the edge of the first substrate (1), the first arc surface (13) has a fifth dimension $L_5$ along the first direction, the second arc surface (14) has a sixth dimension $L_6$ along the first direction, satisfying:

$$0.01 \leq L_5/L_6 \leq 1.$$

8. The silicon-on-insulator wafer according to claim 7, wherein the silicon-on-insulator wafer further satisfies: $50\mu m \leq L_5 \leq 80\mu m$; $220\mu m \leq L_6 \leq 450\mu m$.

9. The silicon-on-insulator wafer according to any one of claims 6 to 8, wherein further comprises:

a first oxide layer (3), the first oxide layer (3) is disposed between the first substrate (1) and the top silicon layer (2), the first oxide layer (3) is in contact with the first surface (11);
a second oxide layer (4), the second oxide layer (3) is disposed on a side of the first substrate (1) facing away from the top silicon layer (2), the second oxide layer (3) is in contact with the second surface (12).

10. The silicon-on-insulator wafer according to any one of claims 1 to 9, wherein the top silicon layer (2) has a thickness along a second direction, the second direction is perpendicular with the first direction; the thickness of the top silicon layer (2) in the second direction is 3 to $20\mu m$.

11. The silicon-on-insulator wafer according to any one of claims 6 to 9, wherein a distance between the first surface (11) and the second surface (12) is 400 to $1000\mu m$.

12. The silicon-on-insulator wafer according to claim 10, wherein a thickness of the first oxide layer (3) in the second direction is 0.1 to $2\mu m$; a thickness of the second oxide layer (4) in the second direction is 0.1 to $2\mu m$.

13. A preparation method of a silicon-on-insulator wafer, wherein comprising following steps:

providing a first substrate (1), the first substrate (1) comprises a first surface (11), wherein, the first surface (11) has a maximum dimension $D_{max}$ along a first direction, the first surface (11) has a second dimension $D_2$ along the first direction, satisfying $100\mu m \leq D_{max} - D_2 \leq 500\mu m$;
providing a second substrate (5), the second substrate (5) comprises a third surface (51);
contacting the third surface (51) with the first surface (11), so that the second substrate (5) and the first substrate (1) are bonded and annealed, and the second substrate (5) comprises a bonding region (501) and a separation region (502); the separation region (502) is disposed around the bonding region (501) to connect an edge of the bonding region (501);
thinning a side of the second substrate (5) facing away from the third surface (51), so that the separation region (502) falls off;

forming, by the bonding region (501), a top silicon layer (2) on the first substrate (1).

14. The preparation method of a silicon-on-insulator wafer according to claim 13, wherein the maximum dimension $D_{max}$ and the second dimension $D_2$ satisfy: $100\mu m \leq D_{max} - D_2 \leq 160\mu m$.

15. The preparation method of a silicon-on-insulator wafer according to any one of claims 13 to 14, wherein the top silicon layer (2) has a first dimension $D_1$ along the first direction, satisfying: $D_{max} - D_1 \leq 2$ mm.

16. The preparation method of a silicon-on-insulator wafer according to any one of claims 13 to 15, wherein after thinning a side of the second substrate (5) facing away from the third surface (51), the side of the second substrate (5) facing away from the third surface (51) comprises a stress damage layer; the step of forming, by the bonding region (501), a top silicon layer (2) on the first substrate (1) comprises:
performing chemical mechanical polishing on a side of the second substrate (5) facing away from the third surface (51) to remove the stress damage layer firstly; forming the top silicon layer (2) after performing chemical mechanical polishing on the bonding region (501).

17. The preparation method of a silicon-on-insulator wafer according to any one of claims 13 to 16, wherein the bonding region (501) has an eighth dimension $D_0$ along the first direction, the top silicon layer (2) has a first dimension $D_1$ along the first direction, satisfying:

$$D_1 - D_0 \leq 0.1 \text{ mm}.$$

18. The preparation method of a silicon-on-insulator wafer according to any one of claims 13 to 17, wherein the top silicon layer (2) has a first dimension $D_1$ along the first direction; the first dimension $D_1$, satisfying:

$$0.1 \leq (D_{max} - D_2) / (D_{max} - D_1) \leq 1.$$

19. The preparation method of a silicon-on-insulator wafer according to any one of claims 13 to 18, wherein the first substrate (1) further comprises a second surface (12) disposed along a second direction and facing away from the first surface (12); the second substrate (5) further comprises a fourth surface (52) disposed along a second direction and facing away from the third surface (51);
the second surface (12) has a third dimension $D_3$ along the first direction, the fourth surface (52) has a third dimension $D_4$ along the first direction, satisfying:

$$1 \leq D_2 / D_3 \leq 1.5; \ 1 \leq D_2 / D_4 \leq 1.5.$$

20. The preparation method of a silicon-on-insulator wafer according to claim 19, wherein a first arc surface (13) is disposed from an edge of the first surface (11) to an edge of the first substrate (1), a second arc surface (14) is disposed from an edge of the second surface (12) to the edge of the first substrate (1), the first arc surface (13) is provided with a fifth dimension $L_5$ along the first direction, the second arc surface (14) is provided with a fifth dimension $L_6$ along the first direction, satisfying: $0.01 \leq L_5 / L_6 \leq 1$.

21. The preparation method of a silicon-on-insulator wafer according to claim 19, wherein a third arc surface (53) is disposed from an edge of the third surface (51) to an edge of the second substrate (5), a fourth arc surface (54) is disposed from an edge of the fourth surface (52) to the edge of the second substrate (5), the third arc surface (53) is connected with the fourth arc surface (54); the third arc surface (53) is provided with a seventh dimension $L_7$ along the first direction, the fourth arc surface (54) is provided with a sixth dimension $L_8$ along the first direction, satisfying: $0.01 \leq L_7 / L_8 \leq 1; \ 0.01 \leq L_7 / L_5 \leq 1$.

22. The preparation method of a silicon-on-insulator wafer according to any one of claims 19 to 21, wherein after providing the first substrate (1), further comprises:
oxidizing the first substrate (1) to form a first oxide layer (3) on the first surface (11) and/or to form a second oxide layer (4) on the second surface (12).

23. The preparation method of a silicon-on-insulator wafer according to any one of claims 13 to 21, wherein the annealing specifically refers to: under the environment of the nitrogen or oxygen, raising the temperature to 900 to 1200 °C at a rate of 2 to 5 °C / min, then keep for 4 to 6 hours.

24. The preparation method of a silicon-on-insulator wafer according to any one of claims 13 to 22, wherein thinning a side of the second substrate (5) facing away from the third surface (51), the thinning is mechanical grinding.

25. The preparation method of a silicon-on-insulator wafer according to claim 16, wherein the removal amount of the chemical mechanical polishing is 4 to 5μm.

26. A semiconductor apparatus, wherein the semiconductor apparatus comprises the silicon-on-insulator wafer according to any one of claims 1 to 12; or, the semiconductor apparatus comprises a silicon-on-insulator wafer obtained by the preparation method of a silicon-on-insulator wafer according to any one of claims 13 to 25.

FIG. 1

FIG. 2

FIG. 3

$L_7$

51

5

53

52

$D_4$

$L_8$

54

FIG. 4

2

3

1

4

FIG. 5

501 502

1

FIG. 6

502

$D_0$

501

1

FIG. 7

FIG. 8

| **INTERNATIONAL SEARCH REPORT** | International application No. |
|---|---|
| | **PCT/CN2022/143558** |

**A. CLASSIFICATION OF SUBJECT MATTER**

H01L21/02(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNTXT, ENTXTC, VEN, CNTXT: 半径, 边缘, 衬底, 尺寸, 倒角, 倒圆, 硅片, 基板, 基材, 基底, 切角, 圆角, 直径, 长度, 宽度, SOI, 绝缘体上硅, 键合, substrate, wafer, egde, trim+, insulat+, fillet, round+, diameter, radius, width, length

**C. DOCUMENTS CONSIDERED TO BE RELEVANT**

| Category* | Citation of document, with indication, where appropriate, of the relevant passages | Relevant to claim No. |
|---|---|---|
| Y | CN 102725823 A (SHINETSU HANDOTAI KK) 10 October 2012 (2012-10-10) description, paragraphs 35-46, and figures 1-3 | 1-12, 19-22, 26 |
| Y | US 20111207294 A1 (M. NAKANISHI et al.) 25 August 2011 (2011-08-25) description, paragraphs 38-46 and 62-65, and figures 1-2 and 9-10 | 3-5, 13-26 |
| Y | CN 101226904 A (SHANGHAI SHENHE THERMO-MAGENETIC ELECTRONIC CO., LTD. et al.) 23 July 2008 (2008-07-23) description, page 3, paragraphs 2-3, and figure 4 | 1-26 |
| A | CN 102194667 A (SOITEC SILICON ON INSULATOR et al.) 21 September 2011 (2011-09-21) entire document | 1-26 |
| A | CN 115229346 A (KIOXIA HOLDINGS CORPORATION) 25 October 2022 (2022-10-25) entire document | 1-26 |
| A | CN 1669122 A (SOITEC SILICON ON INSULATOR) 14 September 2005 (2005-09-14) entire document | 1-26 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 June 2023** | **14 June 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2022/143558**

**C.** DOCUMENTS CONSIDERED TO BE RELEVANT

| Category* | Citation of document, with indication, where appropriate, of the relevant passages | Relevant to claim No. |
|---|---|---|
| A | US 2014273480 A1 (ST MICROELECTRONICS SA. et al.) 18 September 2014 (2014-09-18) entire document | 1-26 |

Form PCT/ISA/210 (second sheet) (July 2022)

<table>
<tr><td colspan="2" align="center"><strong>INTERNATIONAL SEARCH REPORT</strong><br>Information on patent family members</td><td colspan="2">International application No.<br><strong>PCT/CN2022/143558</strong></td></tr>
</table>

| Patent document cited in search report | | | Publication date (day/month/year) | Patent family member(s) | | | Publication date (day/month/year) |
|---|---|---|---|---|---|---|---|
| CN | 102725823 | A | 10 October 2012 | US | 2012289025 | A1 | 15 November 2012 |
| | | | | US | 8603897 | B2 | 10 December 2013 |
| | | | | EP | 2530704 | A1 | 05 December 2012 |
| | | | | EP | 2530704 | A4 | 03 July 2013 |
| | | | | EP | 2530704 | B1 | 20 April 2016 |
| | | | | WO | 2011092795 | A1 | 04 August 2011 |
| | | | | JP | 2011155200 | A | 11 August 2011 |
| | | | | JP | 5521582 | B2 | 18 June 2014 |
| | | | | KR | 20120116444 | A | 22 October 2012 |
| | | | | KR | 101645634 | B1 | 05 August 2016 |
| US | 2011207294 | A1 | 25 August 2011 | JP | 2011171647 | A | 01 September 2011 |
| | | | | JP | 5571409 | B2 | 13 August 2014 |
| | | | | US | 8445360 | B2 | 21 May 2013 |
| | | | | US | 2013237033 | A1 | 12 September 2013 |
| | | | | US | 8748289 | B2 | 10 June 2014 |
| CN | 101226904 | A | 23 July 2008 | | None | | |
| CN | 102194667 | A | 21 September 2011 | EP | 2363879 | A2 | 07 September 2011 |
| | | | | EP | 2363879 | A3 | 22 February 2012 |
| | | | | FR | 2957190 | A1 | 09 September 2011 |
| | | | | FR | 2957190 | B1 | 27 April 2012 |
| | | | | TW | 201139147 | A | 16 November 2011 |
| | | | | TWI | 462834 | B | 01 December 2014 |
| | | | | SG | 173950 | A1 | 29 September 2011 |
| | | | | US | 2011230005 | A1 | 22 September 2011 |
| | | | | US | 8372728 | B2 | 12 February 2013 |
| | | | | JP | 2011181919 | A | 15 September 2011 |
| | | | | JP | 5351191 | B2 | 27 November 2013 |
| | | | | KR | 20110099626 | A | 08 September 2011 |
| | | | | KR | 101299719 | B1 | 28 August 2013 |
| CN | 115229346 | A | 25 October 2022 | JP | 2022167037 | A | 04 November 2022 |
| | | | | US | 2022344159 | A1 | 27 October 2022 |
| | | | | TW | 202242559 | A | 01 November 2022 |
| CN | 1669122 | A | 14 September 2005 | JP | 2005516392 | A | 02 June 2005 |
| | | | | JP | 4549063 | B2 | 22 September 2010 |
| | | | | US | 2005032330 | A1 | 10 February 2005 |
| | | | | US | 6974760 | B2 | 13 December 2005 |
| | | | | US | 2005266659 | A1 | 01 December 2005 |
| | | | | US | 7262113 | B2 | 28 August 2007 |
| | | | | FR | 2835097 | A1 | 25 July 2003 |
| | | | | FR | 2835097 | B1 | 14 October 2005 |
| | | | | DE | 60307419 | D1 | 21 September 2006 |
| | | | | DE | 60307419 | T2 | 29 March 2007 |
| | | | | EP | 1468445 | A2 | 20 October 2004 |
| | | | | EP | 1468445 | B1 | 09 August 2006 |
| | | | | TW | 200306620 | A | 16 November 2003 |
| | | | | TWI | 266362 | B | 11 November 2006 |
| | | | | KR | 20040077795 | A | 06 September 2004 |
| | | | | KR | 100767138 | B1 | 15 October 2007 |
| | | | | AT | 336077 | T | 15 September 2006 |

Form PCT/ISA/210 (patent family annex) (July 2022)

International application No.

**PCT/CN2022/143558**

| Patent document cited in search report | | | Publication date (day/month/year) | Patent family member(s) | | | Publication date (day/month/year) |
|---|---|---|---|---|---|---|---|
| | | | | WO | 03063213 | A2 | 31 July 2003 |
| | | | | WO | 03063213 | A3 | 15 January 2004 |
| US | 2014273480 | A1 | 18 September 2014 | FR | 3003395 | A1 | 19 September 2014 |
| | | | | FR | 3003395 | B1 | 29 May 2015 |
| | | | | EP | 2779223 | A1 | 17 September 2014 |
| | | | | EP | 2779223 | B1 | 23 November 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211652519